Europäisches Patentamt

European Patent Office

Office européen des brevets

(19)

(11) EP 0 875 937 A2

(12) **EUROPÄISCHE PATENTANMELDUNG**

(43) Veröffentlichungstag:
04.11.1998 Patentblatt 1998/45

(51) Int. Cl.⁶: $H01L\ 27/108$, $H01L\ 21/8242$

(21) Anmeldenummer: 98106069.2

(22) Anmeldetag: 02.04.1998

(84) Benannte Vertragsstaaten:
AT BE CH CY DE DK ES FI FR GB GR IE IT LI LU
MC NL PT SE
Benannte Erstreckungsstaaten:
AL LT LV MK RO SI

(30) Priorität: 02.05.1997 DE 19718721

(71) Anmelder:
SIEMENS AKTIENGESELLSCHAFT
80333 München (DE)

(72) Erfinder:
• Hofmann, Franz, Dr.
80995 München (DE)
• Risch, Lothar, Dr.
85579 Neubiberg (DE)
• Rösner, Wolfgang, Dr.
81739 München (DE)

(54) **DRAM-Zellenanordnung und Verfahren zu deren Herstellung**

(57) Die DRAM-Zellenanordnung umfaßt pro Speicherzelle einen vertikalen MOS-Transistor, dessen erste Source/Drain-Gebiete (S/D1) jeweils zu zwei benachbarten Transistoren gehören und an eine Bitleitung (Bl) angrenzen, dessen zweite Source/Drain-Gebiete (S/D2) mit einem Speicherknoten (Sp) verbunden sind, und dessen Gateelektrode (G) genau zwei Flanken aufweist, an die ein Gateoxid (I2) angrenzt. Die DRAM-Zellenanordnung ist unter Verwendung von drei Masken mit einer Speicherzellenfläche von $4F^2$ herstellbar, wobei F die in der jeweiligen Technologie minimal herstellbare Strukturgröße ist.

FIG 8

**Beschreibung**

In DRAM-Zellenanordnungen, d.h. Speicherzellen-Anordnungen mit dynamischem, wahlfreiem Zugriff, werden fast ausschließlich sog. Eintransistor-Speicherzellen eingesetzt. Eine Eintransistor-Speicherzelle umfaßt einen Auslesetransistor und einen Speicherkondensator. In dem Speicherkondensator ist die Information in Form einer elektrischen Ladung gespeichert, die eine logische Größe, 0 oder 1, darstellt. Durch Ansteuerung des Auslesetransistors über eine Wortleitung kann diese Information über eine Bitleitung ausgelesen werden.

Da von Speichergeneration zu Speichergeneration die Speicherdichte zunimmt, muß die benötigte Fläche der Eintransistor-Speicherzelle von Generation zu Generation reduziert werden. Da der Reduktion der Strukturgrößen durch die minimale in der jeweiligen Technologie herstellbare Strukturgröße F Grenzen gesetzt sind, ist dies auch mit einer Veränderung der Eintransistor-Speicherzelle verbunden. So wurden bis zur 1MBit-Generation sowohl der Auslesetransistor als auch der Speicherkondensator als planare Bauelemente realisiert. Ab der 4MBit-Speichergeneration mußte eine weitere Flächenreduzierung durch eine dreidimensionale Anordnung von Auslesetransistor und Speicherkondensator erfolgen.

Eine Möglichkeit besteht darin, den Speicherkondensator nicht planar, sondern in einem Graben zu realisieren (siehe z.B. K. Yamada et al. „A deep trenched Capacitor technology for 4 MBit DRAMs", Proc. Intern. Electronic Devices and Materials IEDM 85, Seite 702).

Eine andere Möglichkeit besteht in der Verwendung vertikaler MOS-Transistoren wie z.B. in US-PS 5 376 575 beschrieben. Jeder vertikale MOS-Transistor umfaßt im dort beschriebenen Herstellungsverfahren zwei gegenüberliegende Flanken eines Grabens, entlang dem eine Bitleitung verläuft. Im oberen Bereich der Flanken sind dotierte Gebiete vorgesehen, die als Draingebiet der MOS-Transistoren wirken. Die Oberfläche der Flanken ist mit Gateoxid versehen. Es ist eine Gateelektrode vorgesehen, die die gegenüberliegenden Oberflächen des Gateoxids bedeckt. Die Gateelektrode ist gegen die darunter angeordnete vergrabene Bitleitung und gegen einen darüber angeordneten Speicherknoten jeweils durch eine isolierende Schicht isoliert. In der Oberfläche des Substrats sind flache Gräben vorgesehen, die quer zu den Bitleitungen verlaufen und in denen quer zu den Bitleitungen verlaufende Wortleitungen angeordnet sind. Die Wortleitungen grenzen seitlich an die Gateelektrode an und sind so mit dieser verbunden. Die mit diesem Verfahren kleinste erreichbare Fläche einer Speicherzelle beträgt 6 $F^2$.

Aus DE 38 44 120 A1 ist eine DRAM-Anordnung bekannt, in der in einem Halbleitersubstrat Gräben vorgesehen sind. Ein Drain-Gebiet ist am Boden des Grabens vorgesehen. An der Oberfläche des Substrats ist ein Source-Gebiet vorgesehen. Die Seitenwände des Grabens sind mit Gateoxid und Gateelektrode versehen und wirken als Kanalgebiet. Die Gateelektroden sind in eine Isolationsschicht eingebettet, in der ein Kontaktloch bis auf die Oberfläche des Boden des Grabens befindlichen Draingebiets reicht und mit einer Elektrode versehen ist. Seitlich des Grabens ist an der Oberfläche des Halbleitersubstrats ein Kondensator vorgesehen. Die laterale Anordnung von Kondensator und Transistor bedeutet einen erhöhten Flächenbedarf der Speicherzelle.

In P. Chatterjee et al. IEDM 86 Seiten 128-131 wird eine DRAM-Zellenanordnung erwähnt, bei der Auslesetransistoren als vertikale Transistoren ausgebildet sind. Ein Auslesetransistor weist ein erstes Source/Drain-Gebiet auf, das eine Gateelektrode ringförmig umgibt und Teil einer Bitleitung ist. Ein zweites Source/Drain-Gebiet des Auslesetransistors wird durch Ausdiffusion von Dotierstoff eines in einer Vertiefung realisierten Speicherknotens, der unterhalb der Gateelektrode angeordnet ist, erzeugt. Wortleitungen, die zum Teil aus Gateelektroden bestehen, verlaufen über den Bitleitungen. Der Auslesetransistor umfaßt zumindest zu den Bitleitungen parallele Flanken der Gateelektrode. Die Fläche einer Speicherzelle 9 $F^2$.

In DE 195 19 160 C1 ist eine DRAM-Zellenanordnung vorgeschlagen worden, die pro Speicherzelle einen vertikalen MOS-Transistor umfaßt, dessen erstes Source/Drain-Gebiet mit einem Speicherknoten eines Speicherkondensators verbunden ist, dessen Kanalgebiet ringförmig von einer Gateelektrode umschlossen wird und dessen zweites Source-Drain-Gebiet mit einer vergrabenen Bitleitung verbunden ist. Der Speicherkondensator ist entweder ein planarer Kondensator oder ein Stapelkondensator. Die DRAM-Zellen-Anordnung ist mit einer Speicherzellenfläche von 4 $F^2$ herstellbar.

Die Fläche einer Speicherzelle eines DRAM in der 1GBit-Generation soll nur etwa 0.2$\mu m^2$ betragen. Der Speicherkondensator muß dabei eine Kapazität von 20 bis 30fF aufweisen. Eine derartige Kapazität ist bei einer Zellfläche, wie sie bei der 1GBit-Generation zur Verfügung steht, sowohl bei planaren als auch bei Stapelkondensatoren nur unter großem Aufwand erreichbar: Bei planaren Kondensatoren muß ein Kondensatordielektrikum aus einem Material mit einer besonders hohen Dielektrizitätskonstanten aufgebracht werden. Da die hierfür geeigneten bekannten ferro- und paraelektrischen Materialien die üblichen zur Herstellung von DRAM's verwendeten Apparaturen verunreinigen, muß für das Aufbringen des Dielektrikums das herzustellende DRAM in eine zusätzliche zweite Apparatur verlegt werden. Beim Stapelkondensator wird zur Vergrößerung der Fläche und damit der Kapazität des Speicherkondensators eine relativ komplizierte Struktur aus Polysilizium benötigt, die umso schwieriger herstellbar ist, je kleiner die Zellfläche ist.

Der Erfindung liegt das Problem zugrunde, eine DRAM-Zellenanordnung anzugeben, die als Speicherzellen Eintransistor-Speicherzellen umfaßt und die in der für die 1GBit Generation erforderlichen Packungsdichte herstellbar ist. Ferner soll ein Herstellungsverfahren für eine solche DRAM-Zellenanordnung angegeben werden.

Dieses Problem wird gelöst durch eine DRAM-Zellenanordnung gemäß Anspruch 1 sowie ein Verfahren zu deren Herstellung gemäß Anspruch 8. Weitere Ausgestaltungen der Erfindung gehen aus den übrigen Ansprüchen hervor.

In der erfindungsgemäßen DRAM-Zellenanordnung sind Eintransistor-Speicherzellen vorgesehen, in denen der Auslesetransistor als vertikaler MOS-Transistor ausgebildet ist. Jeder MOS-Transistor umfaßt zwei gegenüberliegende, parallel zur Wortleitung verlaufende und an ein Gateoxid angrenzende Flanken einer Gateelektrode. Der MOS-Transistor besitzt genau zwei erste Source/Drain-Gebiete, die räumlich getrennt entlang einer Bitleitung, über die sie verbunden sind, angeordnet sind. Jedes erste Source/Drain-Gebiet gehört zu zwei entlang der Bitleitung benachbarten Transistoren, was zu einer kleinen Zellfläche führt.

Es ist vorteilhaft, den Speicherkondensator in einem Graben zu realisieren. Der Aufwand zur Herstellung solcher Kondensatoren für die 1GBit-Generation ist deutlich geringer als der zur Herstellung planarer Kondensatoren oder Stapelkondensatoren.

Werden Elemente selbstjustiert angebracht, d.h. ohne Verwendung zu justierender Masken, kann eine Verkleinerung der Zellfläche erreicht werden, da keine Justiertoleranzen berücksichtigt werden müssen. Gemäß einer Ausführungsform werden die Speicherknoten selbstjustiert unter den Wortleitungen angebracht und von benachbarten Speicherknoten isoliert. Außerdem werden die Kontakte der ersten Source/Drain-Gebiete zu den Bitleitungen selbstjustiert geöffnet. Dies erlaubt die Herstellung von Zellflächen der Größe $4F^2$ mit lediglich 3 Masken.

Zweite Source/Drain-Gebiete des MOS-Transistors sind mit einem Speicherknoten verbunden. Sie werden bevorzugt durch Ausdiffusion von Dotierstoff aus den Speicherknoten in eine geeignete strukturierte Schicht hergestellt. Dadurch werden die Speicherknoten selbstjustiert mit den zweiten Source/Drain-Gebieten verbunden und die Zellfläche wird klein gehalten. Auch die Junctiontiefe, d.h. die Strecke minimalen Abstandes zwischen Source und Drain senkrecht zum Stromfluß und senkrecht zur Gateelektrode, wird klein gehalten, was Kurzkanaleffekte, wie punch through, positiv beeinflußt.

Es liegt im Rahmen der Erfindung, die Gateelektrode als Teil der Wortleitung auszubilden, was die Zahl der nötigen Prozeßschritte verringert, sowie eine selbstjustierte Verbindung zwischen Gateelektrode und Wortleitung bewirkt.

Bei der Verwendung von in Gräben realisierten Kondensatoren ist es vorteilhaft, unterhalb der Schicht, die als Kondensatorplatte dient, eine weitere, von einem zum Leitfähigkeitstyp der Kondensatorplatte entgegengesetzten Leitfähigkeitstyp dotierte Schicht vorzusehen. Dadurch wird das Substrat von der Kondensatorplatte, die separat an ein Potential angeschlossen werden kann, elektrisch isoliert.

Um gemäß einer Ausführungsform beim Öffnen der Kontakte der ersten Source/Drain-Gebiete zu den Bitleitungen $SiO_2$ nicht zu tief zu ätzen, was zum Kurzschluß zwischen den Wortleitungen und den Bitleitungen führen kann, ist es vorteilhaft zu Beginn der DRAM-Herstellung, auf das Substrat eine Schicht aus Siliziumnitrid aufzubringen. Beim Ätzen von $SiO_2$ liefert die Freilegung der Schicht aus Siliziumnitrid durch Änderung physikalischer Gegebenheiten, wie etwa der Gaszusammensetzung, ein Endpunktsignal für die Ätzung. Um Oberflächenschäden des Substrats durch Siliziumnitrid zu vermeiden, ist es vorteilhaft, vor Erzeugung der Siliziumnitridschicht eine dünne $SiO_2$-Schicht aufzutragen.

Im folgenden wird die Erfindung anhand des Ausführungsbeispiels, die in den Figuren dargestellt sind, näher erläutert.

Figur 1     zeigt einen Schnitt senkrecht zu einer Oberfläche eines ersten Substrats, das einen dotierten Bereich aufweist, über dem drei Schichten aus Halbleitermaterial angeordnet sind. Darüber ist eine erste $SiO_2$-Schicht aufgebracht.

Figur 2     zeigt den Schnitt aus Figur 1 nach der Erzeugung erster Gräben.

Figur 3     zeigt einen Schnitt senkrecht zum Schnitt aus Figur 2 entlang eines ersten Grabens nach Bildung einer zweiten die ersten Gräben füllenden $SiO_2$-Schicht und nach Ätzen von $SiO_2$ zur Erzeugung zweiter Gräben. Dieser Schnitt behält sein Aussehen auch nach den Prozeßschritten zu Figur 5 und 6.

Figur 4     zeigt einen zu Figur 3 parallelen Schnitt.

Figur 5     zeigt den Schnitt aus Figur 4 nach Ätzen von Halbleitermaterial, was die Bildung der zweiten Gräben abschließt, und nach Erzeugung einer ersten Isolationsstruktur.

Figur 6     zeigt den Schnitt aus Figur 5 nach Füllen der zweiten Gräben mit Halbleitermaterial bis zu einer ersten Höhe und nach Entfernen von Teilen der ersten Isolationsstruktur, wodurch Kondensatordielektrika entstehen.

Figur 7     zeigt den Schnitt aus Figur 6 nach Erzeugung von zweiten Source/Drain-Gebieten, Gateoxiden, Wortleitungen und Gateelektroden.

Figur 8    zeigt den Schnitt aus Figur 7 nach Erzeugung von Bitleitungen.

Figur 9    zeigt den Schnitt aus Figur 2 entlang eines zweiten Grabens nach Erzeugung der Bitleitungen.

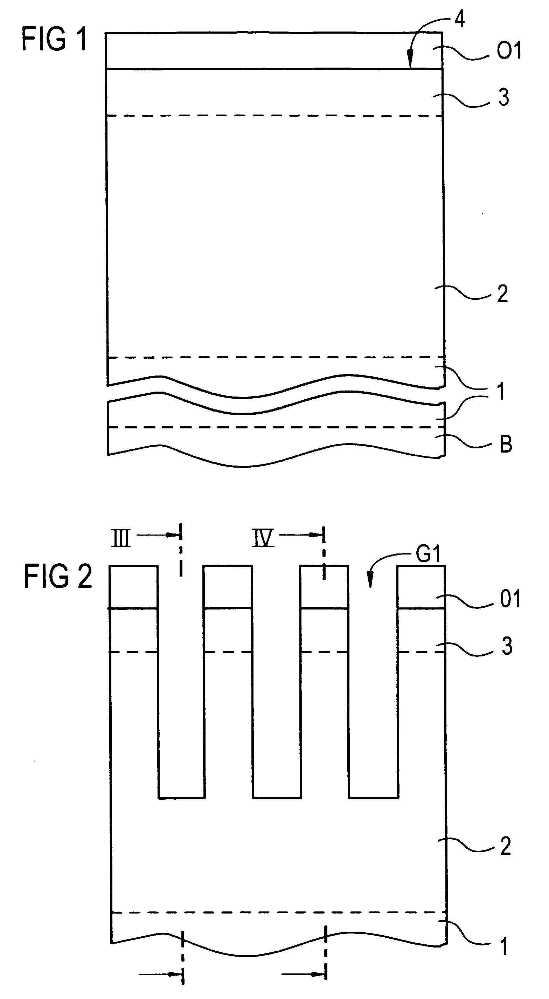

Ausgangsmaterial ist ein Substrat aus z.B. monokristallinem Silizium, das in einem Bereich B von einem ersten Leitfähigkeitstyp dotiert ist. Der Bereich B weist z.B. eine p-Dotierung mit einer Dotierstoffkonzentration von ca. $3*10^{16} cm^{-3}$ auf und ist mit einer ersten Schicht 1, die von einem zweitem, dem ersten Leitfähigkeitstyp entgegengesetzten Leitfähigkeitstyp mit einer Dotierstoffkonzentration von ca. $10^{20} cm^{-3}$ dotiert ist, mit einer zweiten Schicht 2, die vom ersten Leitfähigkeitstyp mit einer Dotierstoffkonzentration von ca. $3*10^{17} cm^{-3}$ dotiert ist, und einer dritten Schicht 3, die vom zweiten Leitfähigkeitstyp mit einer Dotierstoffkonzentration von ca. $10^{21} cm^{-3}$ dotiert ist, versehen (s. Fig. 1). Die erste Schicht 1, die zweite Schicht 2 und die dritte Schicht 3 werden z.B. durch epitaktisches Aufwachsen erzeugt. Die dritte Schicht 3 bildet eine Oberfläche 4 des Substrates. Die erste Schicht 1 weist eine Dicke von ca. $9 \mu m$, die zweite Schicht 2 eine Dicke von ca. $1 \mu m$ und die dritte Schicht 3 eine Dicke von ca. 200nm auf.

Auf die Oberfläche 4 wird in einem TEOS-Verfahren eine erste ca. 150 nm dicke $SiO_2$-Schicht O1 abgeschieden (s. Figur 1). Mit Hilfe einer ersten Fotolackmaske (nicht dargestellt) wird die erste $SiO_2$-Schicht O1 strukturiert, wobei Teile der Oberfläche 4 freigelegt werden, um erste Gräben G1 erzeugen zu können.

Nach Entfernen der ersten Fotolackmaske werden in einem anisotropen Trockenprozeß selektiv zu $SiO_2$ die ersten Gräben G1 geätzt (s. Figur 2). Als Ätzprozeß, bei dem Silizium selektiv zu $SiO_2$ angegriffen wird, ist z.B. HBr, $NF_3$, He, $O_2$ geeignet. Die ersten Gräben G1 werden mit einer Tiefe von ca. 800nm erzeugt und reichen bis in die zweite Schicht 2. Parallel zur Oberfläche 4 weisen die ersten Gräben G1 einen streifenförmigen Querschnitt auf und verlaufen im wesentlichen parallel über das gesamte Zellenfeld. Die ersten Gräben G1 weisen eine Weite von ca. 200nm und eine Länge von ca. $50 \mu m$ auf. Der Abstand zwischen den Mitten benachbarter erster Gräben G1 beträgt ca. 400nm, das entspricht zwei mal der minimalen Struktur Größe F = 200nm in der verwendeten Technologie.

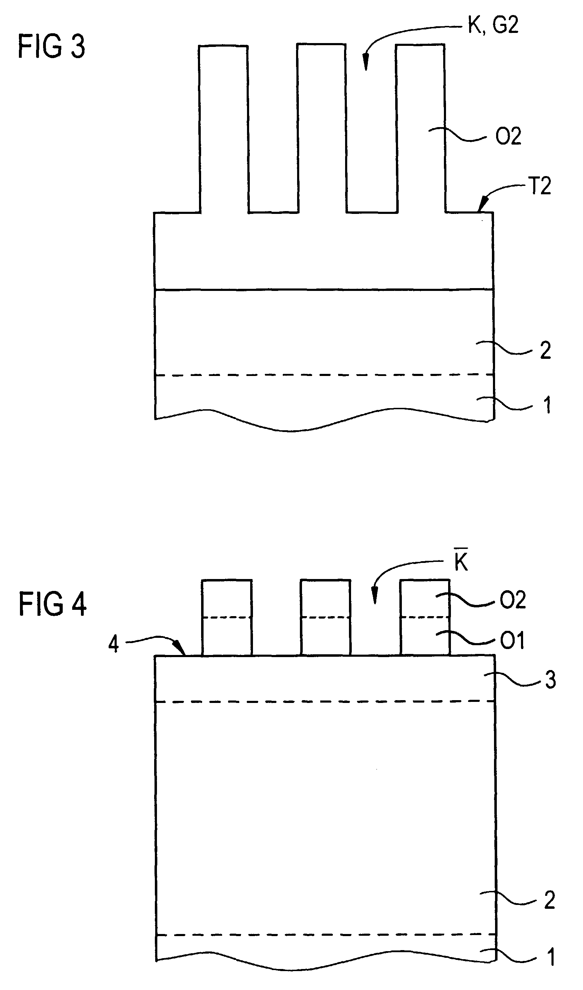

Durch Abscheidung einer zweiten z.B. 150 nm dicken $SiO_2$-Schicht O2 in einem TEOS-Verfahren werden die ersten Gräben G1 gefüllt. Die Oberfläche 4 wird von Teilen der ersten $SiO_2$-Schicht O1 und von Teilen der zweiten $SiO_2$-Schicht O2, d.h. mit insgesamt 300 nm $SiO_2$ bedeckt (s. Figur 4).

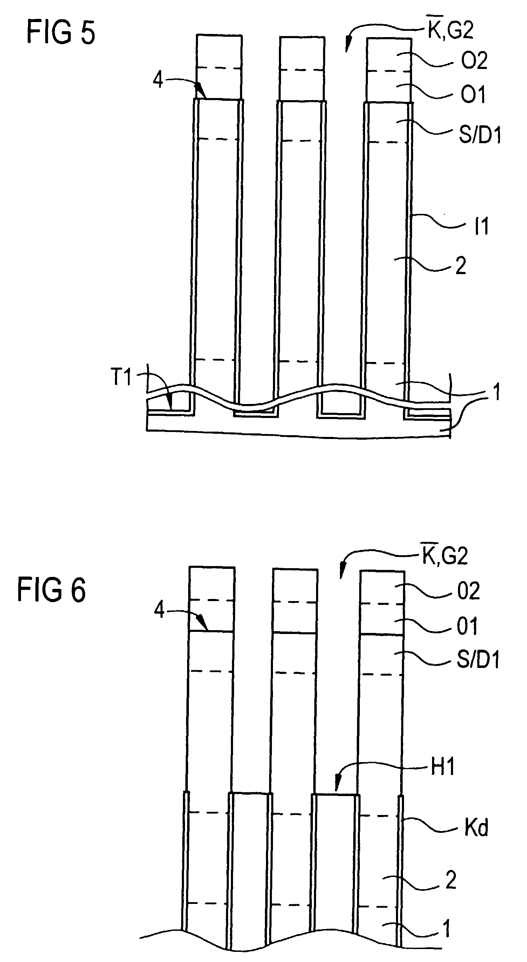

Zur Bildung von zweiten Gräben G2 wird mit Hilfe einer zweiten Fotolackmaske $SiO_2$ selektiv zu Silizium durch anisotropes Trockenätzen bis zu einer zweiten Tiefe T2, die oberhalb einer Grenzfläche zwischen der ersten Schicht 1 und der zweiten Schicht 2 und unterhalb einer Grenzfläche zwischen der zweiten Schicht 2 und der dritten Schicht 3 liegt und ca. 400nm ab der Oberfläche 4 beträgt, geätzt (s. Figur 3). Dabei werden Teile der Oberfläche 4, die wegen der Selektivität der Ätzung nicht angegriffen wird, freigelegt (s. Figur 4). Als Ätzprozeß, bei dem $SiO_2$ selektiv zu Silizium angegriffen wird, ist z.B. $CHF_3$, $CF_4$, und/oder Ar geeignet. Anschließend wird Silizium selektiv zu $SiO_2$ bis zu einer ersten Tiefe T1 innerhalb der ersten Schicht 1 geätzt. Die erste Tiefe T1 liegt z.B. 10 $\mu m$ unterhalb der Oberfläche 4. Die erzeugten zweiten Gräben G2 verlaufen z.B. senkrecht zu den ersten Gräben G1 (s. Figur 5). Die zweiten Gräben G2 weisen eine Weite von ca. 200nm und eine Länge von ca. $50 \mu m$ auf. Der Abstand zwischen den Mitten benachbarter zweiter Gräben G2 beträgt ca. 400nm. Die teilweise mit $SiO_2$ gefüllten ersten Gräben G1 und die zweiten Gräben G2 kreuzen sich in Kreuzungsgebieten K. Die zweiten Gräben G2 weisen in den Kreuzungsgebieten K die zweite Tiefe T2 auf (s. Figur 3). In zwischen den Kreuzungsgebieten K liegenden Gebieten $\overline{K}$ weisen die zweiten Gräben G2 die erste Tiefe T1 auf (s. Figur 5). In den zwischen den Kreuzungsgebieten K liegenden Gebieten $\overline{K}$ durchtrennen damit die zweiten Gräben G2 die dritte Schicht 3 und die zweite Schicht 2. Parallel zur Oberfläche 4 weisen die zweiten Gräben G2 einen streifenförmigen Querschnitt auf und verlaufen im wesentlichen parallel. Übrigbleibende Teile der dritten Schicht 3, die von den ersten Gräben G1 und den zweiten Gräben G2 begrenzt werden, sind als erste Source/Drain-Gebiete S/D1 geeignet.

Eine erste Isolationsstruktur I1 wird durch thermische Oxidation der an die zweiten Gräben G2 angrenzenden Flächen aus Halbleitermaterial erzeugt (s. Figur 5). Anschließend werden die zweiten Gräben G2 durch Abscheiden von Halbleitermaterial, das vom zweiten Leitfähigkeitstyp mit einer Dotierstoffkonzentration von ca. $10^{21} cm^{-3}$ dotiert ist, gefüllt. Die Dicke des aufgetragenen Halbleitermaterials beträgt ca. 200nm. Anschließend wird selektiv zu $SiO_2$ Silizium geätzt, so, daß die zweiten Gräben G2 in den zwischen den Kreuzungsgebieten K liegenden Gebieten $\overline{K}$ bis zu einer ersten Höhe H1 mit Halbleitermaterial gefüllt sind. Die erste Höhe H1 befindet sich oberhalb einer Grenzfläche zwischen der ersten 1 und zweiten Schicht 2 und unterhalb der zweiten Tiefe T2. Die erste Höhe H1 liegt ca. 600nm unterhalb der Oberfläche 4. Dadurch freigelegte Teile der ersten Isolationsstruktur I1 werden durch einen nassen Ätzprozeß mit HF entfernt. Übrigbleibende Teile der ersten Isolationsstruktur I1 sind als Kondensatordielektrika Kd geeignet (s. Figur 6).

Anschließend werden die zweiten Gräben G2 durch Abscheiden von Halbleitermaterial, das vom zweiten Leitfähigkeitstyp mit einer Dotierstoffkonzentration von ca. $10^{21} cm^{-3}$ dotiert ist, gefüllt. Die Dicke des abgeschiedenen Halbleitermaterials beträgt ca. 200nm. Anschließend wird selektiv zu $SiO_2$ Silizium geätzt, so, daß die zweiten Gräben G2 in den zwischen den Kreuzungsgebieten K liegenden Gebieten $\overline{K}$ bis zu einer zweiten Höhe H2, die oberhalb der ersten Höhe H1 und unterhalb der zweiten Tiefe T2 liegt, mit Halbleitermaterial gefüllt sind. Die zweite Höhe H2 liegt ca. 100nm oberhalb der ersten Höhe H1. Das Halbleitermaterial bis zur zweiten Höhe H2 in den zwischen den Kreuzungsgebieten K liegenden Gebieten $\overline{K}$ der zweiten Gräben G2 sind als Speicherknoten SP geeignet. Die Speicherknoten SP reichen demnach von der zweiten Schicht 2 bis in die erste Schicht 1.

Durch ein RTP-Verfahren diffundiert Dotierstoff aus den Speicherknoten in die zweite Schicht 2. Dadurch entstehende vom zweiten Leitfähigkeitstyp dotierte Gebiete eignen sich als zweite Source/Drain-Gebiete S/D2.

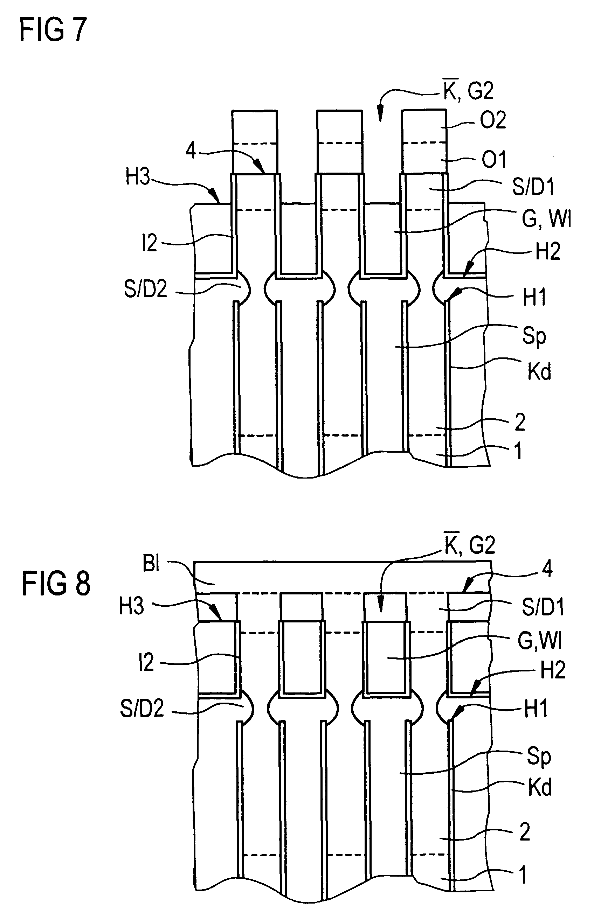

Innerhalb der zweiten Gräben G2 wird durch z.B. thermische Oxidation ein Gateoxid I2 erzeugt. Anschließend wird leitendes Material, das z.B. Polysilizium und/oder Metallsilizid enthält, abgeschieden, um die zweiten Gräben G2 zu füllen. Die Dicke des abgeschiedenen leitenden Materials beträgt ca. 200nm. Selektiv zu $SiO_2$ wird das leitende Material geätzt, so, daß die zweiten Gräben G2 in den zwischen den Kreuzungsgebieten K liegenden Gebieten $\overline{K}$ bis zu einer dritten Höhe H3, die oberhalb der Grenzfläche zwischen der zweiten 2 und dritten Schicht 3 und unterhalb der Oberfläche 4 liegt, mit leitendem Material gefüllt sind (s. Figur 7). Die dritte Höhe H3 liegt ca. 150nm unterhalb der Oberfläche 4. Das abgeschiedene leitende Material bildet Wortleitungen WI, die in den zwischen den Kreuzungsgebieten K liegenden Gebieten $\overline{K}$ als Gateelektroden G geeignet sind. Die Gateelektroden G werden also selbstjustiert über den Speicherknoten Sp hergestellt.

Durch Abscheidung von $SiO_2$ in einem TEOS-Verfahren werden die zweiten Gräben G2 gefüllt. Die Dicke des abgeschiedenen $SiO_2$ beträgt ca. 200nm. Anschließend wird $SiO_2$ selektiv zu Silizium geätzt, bis die Oberfläche 4 freigelegt wird. Durch diesen Schritt werden die erste $SiO_2$-Schicht O1 und die zweite $SiO_2$-Schicht O2 vollständig entfernt. Da an einen Schnitt entlang der Oberfläche 4 nur die ersten Source/Drain-Gebiete S/D1 und isolierende Materialien angrenzen, werden dadurch Kontakte zu den ersten Source/Drain-Gebieten S/D1 selbstjustiert geöffnet.

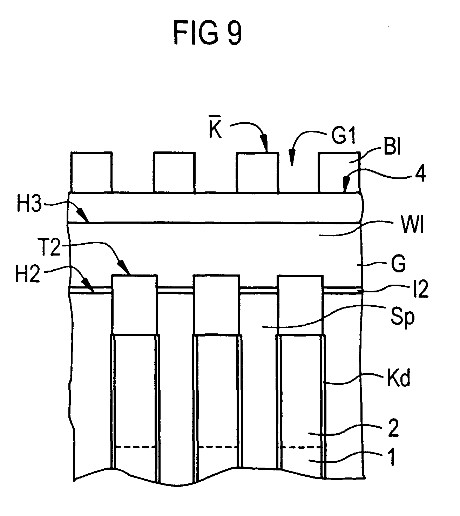

Mit Hilfe einer dritten Fotolackmaske, dessen Form mit der ersten Fotolackmaske übereinstimmt, werden durch Abscheiden und Strukturieren von leitendem Material Bitleitungen BL erzeugt. Die Bitleitungen BI werden so angeordnet, daß sie die ersten Source/Drain-Gebiete S/D1 überlappen (s. Figuren 8 und 9). Das leitende Material enthält z.B. Polysilizium, Metallsilizid und/oder Wolfram.

Jeder MOS-Transistor besteht aus einer Gateelektrode G, die Teil einer Wortleitung WI ist, zwei ersten Source/Drain-Gebieten S/D1, die durch Strukturierung der dritten Schicht 3 entstanden und die mit einer Bitleitung BI überlappen, zwei senkrecht zur Oberfläche 4 verlaufenden Kanalgebieten, die sich innerhalb der zweiten Schicht 2 befinden und an die jeweils ein Gateoxid angrenzt und zwei zweiten Source/Drain-Gebieten S/D2, die durch Ausdiffusion von Dotierstoff aus einem Speicherknoten Sp in die zweite Schicht 2 entstanden und die mit dem Speicherknoten Sp verbunden sind (s. Figur 8). $SiO_2$ in den ersten Gräben G1 isoliert in Wortleitungsrichtung benachbarte Transistoren gegeneinander, sowie Wortleitungen WI von Bitleitungen BI. Die Speicherknoten Sp sind unterhalb den Gateelektroden G angeordnet.

Statt der ersten $SiO_2$-Schicht O1 kann auf der Oberfläche 4 eine Schicht gebildet werden, die aus z.B. drei Teilschichten besteht, von denen eine mittlere ca. 80nm dicke Teilschicht Siliziumnitrid enthält. Eine untere ca. 20nm dicke Teilschicht aus $SiO_2$, die Oberflächenschäden des Substrats durch Siliziumnitrid verhindern soll, wird durch thermische Oxidation erzeugt. Eine obere ca. 50nm dicke Teilschicht aus $SiO_2$ wird z.B. in einem TEOS-Verfahren erzeugt. Bei jedem Ätzprozeß, der Teile der Oberfläche 4 freilegt, muß damit nicht nur $SiO_2$, sondern auch Siliziumnitrid geätzt werden. Diese Alternative verringert die Gefahr, daß beim Öffnen der Kontakte der ersten Source/Drain-Gebiete S/D1 zu tief geätzt wird, was zu einem Kurzschluß zwischen Wortleitungen WI und Bitleitungen BI führen würde (s. Figur 9).

Es sind viele Variationen des Ausführungsbeispiels denkbar, die ebenfalls im Rahmen der Erfindung liegen. Insbesondere können die Abmessungen der vorgestellten Schichten und Gräben nach Belieben an die jeweiligen Erfordernisse angepaßt werden. Dasselbe gilt auch für die vorgeschlagenen Dotierstoffkonzentrationen. Strukturen und Schichten aus $SiO_2$ können durch thermische Oxidation oder durch ein TEOS-Verfahren erzeugt werden.

**Patentansprüche**

1. DRAM-Zellenanordnung,

- bei der Speicherzellen jeweils einen Auslesetransistor und einen Speicherkondensator umfassen,
- bei der der Auslesetransistor ein in einem Substrat aus Halbleitermaterial integrierter vertikaler MOS-Transistor ist,
- bei der der vertikale MOS-Transistor zwei erste Source/Drain-Gebiete (S/D1) aufweist, die getrennt hintereinander entlang einer Bitleitung (BI) angeordnet sind, an die Bitleitung (BI) angrenzen und jeweils zu einem weiteren benachbarten vertikalen MOS-Transistor gehören,
- bei der zwei Kanalgebiete jeweils an ein Gateoxid (I2) angrenzen,
- bei der das Gateoxid (I2) an genau zwei gegenüberliegende Flanken einer Gateelektrode (G) angrenzt,

- bei der die Gateelektrode (G) zwischen den zwei Kanalgebieten angeordnet ist,
- bei der Gateelektroden (G) von entlang einer Wortleitung (Wl) benachbarten vertikalen MOS-Transistoren miteinander verbunden sind,
- bei der der Speicherkondensator einen Speicherknoten (Sp) aufweist, der mit zweiten Source/Drain-Gebieten (S/D2) des vertikalen MOS-Transistors verbunden ist,
- bei der die Gateelektrode (G) und der Speicherknoten (Sp) untereinander angeordnet sind.

2. DRAM-Zellenanordnung,

- bei der Speicherzellen jeweils einen Auslesetransistor und einen Speicherkondensator umfassen,
- bei der der Auslesetransistor ein in einem Substrat aus Halbleitermaterial integrierter vertikaler MOS-Transistor ist,
- bei der der vertikale MOS-Transistor zwei erste Source/Drain-Gebiete (S/D1) aufweist, die getrennt hintereinander entlang einer Bitleitung (Bl) angeordnet sind, an die Bitleitung (Bl) angrenzen und jeweils zu einem weiteren benachbarten vertikalen MOS-Transistor gehören,
- bei der zwei Kanalgebiete jeweils an ein Gateoxid (l2) angrenzen,
- bei der das Gateoxid (l2) an genau zwei gegenüberliegende Flanken einer Gateelektrode (G) angrenzt,
- bei der die Gateelektrode (G) zwischen den zwei Kanalgebieten angeordnet ist,
- bei der Gateelektroden (G) von entlang einer Wortleitung (Wl) benachbarten vertikalen MOS-Transistoren miteinander verbunden sind,
- bei der der Speicherkondensator einen Speicherknoten (Sp) aufweist, der mit zweiten Source/Drain-Gebieten (S/D2) des vertikalen MOS-Transistors verbunden ist,
- bei der die Gateelektrode (G) und der Speicherknoten (Sp) untereinander angeordnet sind,
- bei der die Gateelektrode (G) und der Speicherknoten (Sp) in einem Graben (G2) angeordnet sind.

4. DRAM-Zellenanordnung nach einem der Ansprüche 1 bis 3, bei der Abmessungen eines zu einer Oberfläche (4) des Substrats parallelen Querschnittes der Gateelektrode (G) im wesentlichen mit Abmessungen eines zu der Oberfläche (4) parallelen Querschnittes des Speicherknotens (Sp) übereinstimmen.

5. DRAM-Zellenanordnung nach Anspruch 4,

- bei der sich der Speicherknoten (Sp) unterhalb der Gateelektrode (G) befindet,
- bei der der Speicherknoten (Sp) an seinen zur Wortleitung (Wl) parallelen Flanken mit einem Teil eines Kondensatordielektrikums (Kd) versehen ist, der zur Verbindung des Speicherknotens (Sp) mit den zweiten Source/Drain-Gebieten (S/D2) unterbrochen ist,
- bei der der Speicherknoten (Sp) an zur Bitleitung (Bl) parallelen Flanken mit isolierendem Material, das einen anderen Teil des Kondensatordielektrikums (Kd) umfaßt, versehen ist.

2. DRAM-Zellenanordnung,

- bei der Speicherzellen jeweils einen Auslesetransistor und einen Speicherkondensator umfassen,
- bei der der Auslesetransistor ein in einem Substrat aus Halbleitermaterial integrierter vertikaler MOS-Transistor ist,
- bei der der vertikale MOS-Transistor zwei erste Source/Drain-Gebiete (S/D1) aufweist, die getrennt hintereinander entlang einer Bitleitung (Bl) angeordnet sind, an die Bitleitung (Bl) angrenzen und jeweils zu einem weiteren benachbarten vertikalen MOS-Transistor gehören,
- bei der zwei Kanalgebiete jeweils an ein Gateoxid (l2) angrenzen,
- bei der das Gateoxid (l2) an genau zwei gegenüberliegende Flanken einer Gateelektrode (G) angrenzt,
- bei der die Gateelektrode (G) zwischen den zwei Kanalgebieten angeordnet ist,
- bei der Gateelektroden (G) von entlang einer Wortleitung (Wl) benachbarten vertikalen MOS-Transistoren miteinander verbunden sind,
- bei der der Speicherkondensator einen Speicherknoten (Sp) aufweist, der mit zweiten Source/Drain-Gebieten (S/D2) des vertikalen MOS-Transistors verbunden ist,
- bei der die Gateelektrode (G) und der Speicherknoten (Sp) untereinander angeordnet sind,
- bei der mindestens ein Teil des Kondensatordielektrikums (Kd) bezüglich einer durch die Gateelektrode (G) verlaufenden vertikalen Achse radial weiter außen angeordnet ist, als ein an ihn angrenzender Teil des Speicherknotens (Sp).

3. DRAM-Zellenanordnung,

- bei der Speicherzellen jeweils einen Auslesetransistor und einen Speicherkondensator

6. DRAM-Zellenanordnung nach einem der Ansprüche 1 bis 5,

- bei der die Bitleitung (BI) oberhalb der Wortleitung (WI) verläuft.
- bei der die Wortleitung (WI) sich in Höhe der Gateelektrode (G) befindet.

7. DRAM-Zellenanordnung nach einem der Ansprüche 1 bis 6,

- bei der die ersten (S/D1) und zweiten Source/Drain-Gebiete (S/D2) als dotierte Gebiete im Substrat ausgebildet sind,
- bei der die Bitleitung (BI) und die Wortleitung (WI) Polysilizium, Metallsilizid und/oder Wolfram enthalten.

8. Verfahren zur Herstellung einer DRAM-Zellenanordnung,

- bei dem Speicherzellen mit jeweils einem Auslesetransistor und einem Speicherkondensator erzeugt werden,
- bei dem Bitleitungen (BI) erzeugt werden,
- bei dem der Auslesetransistor als ein in einem Substrat aus Halbleitermaterial integrierter vertikaler MOS-Transistor gebildet wird,
- bei dem der MOS-Transistor zwei erste Source/Drain-Gebiete (S/D1) aufweist, die jeweils zu einem weiteren benachbarten vertikalen MOS-Transistoren gehören und getrennt hintereinander entlang der Bitleitung (BI), an die sie angrenzen, angeordnet sind,
- bei der zwei Kanalgebiete erzeugt werden, die jeweils an ein Gateoxid (I2) angrenzen,
- bei der das Gateoxid (I2) so erzeugt wird, daß es an genau zwei gegenüberliegende Flanken einer Gateelektrode (G) angrenzt,
- bei der die Gateelektrode (G) so erzeugt wird, daß sie zwischen den zwei Kanalgebieten angeordnet ist,
- bei dem der MOS-Transistor zwei zweite Source/Drain-Gebiete (S/D2) aufweist, die jeweils mit einem Speicherknoten (Sp) des Speicherkondensators verbunden sind,
- bei dem Gateelektroden (G) von entlang einer Wortleitung (WI) benachbarten MOS-Transistoren so erzeugt werden, daß sie elektrisch verbunden sind,
- bei dem die Gateelektrode (G) und der Speicherknoten (Sp) untereinander angeordnet werden.

9. Verfahren nach Anspruch 8,

- bei dem eine erste Schicht (1) des Substrats, die von einem ersten Leitfähigkeitstyp dotiert ist, eine zweite Schicht (2) des Substrats, die von einem zweiten, dem ersten Leitfähigkeitstyp entgegengesetzten Leitfähigkeitstyp dotiert ist, und eine dritte Schicht (3) des Substrats, die vom ersten Leitfähigkeitstyp dotiert ist und die an eine Oberfläche (4) des Substrats angrenzt, gebildet werden,

- bei dem erste Gräben (G1), die jeweils streifenförmig sind und im wesentlichen parallel verlaufen und die dritte Schicht (3) durchtrennen, mit Hilfe einer ersten Maske geätzt werden,
- bei dem zweite Gräben (G2), die jeweils streifenförmig und im wesentlichen parallel verlaufen und die dritte Schicht durchtrennen, die die ersten Gräben (G1) in Kreuzungsgebieten (K) kreuzen und in diesen Kreuzungsgebieten (K) flacher als in dazwischenliegenden Gebieten ($\overline{K}$) sind, erzeugt werden,
- bei dem die ersten Source/Drain-Gebiete (S/D1) als übrigbleibende Teile der dritten Schicht (3) entstehen,
- bei dem die ersten Gräben (G1) teilweise mit isolierendem Material versehen werden, welches erste (S/D1) und zweite Source/Drain-Gebiete (S/D2) entlang der Wortleitung (WI) benachbarter MOS-Transistoren voneinander elektrisch isoliert,
- bei dem die zweiten Gräben (G2) mit Kondensatordielektrika (Kd), Speicherknoten (Sp), Gateoxiden (I2) und den Gateelektroden (G) versehen werden,
- bei dem mit Hilfe einer Maske die Bitleitungen (BI) quer zu den Wortleitungen (WI) auf die Oberfläche (4) aufgebracht werden, wodurch die ersten Source/Drain-Gebiete (S/D1) an die Bitleitungen (BI) angrenzen,

10. Verfahren nach Anspruch 9,

- bei dem zuerst die Speicherknoten (Sp) und anschließend die Gateelektroden (G) gebildet werden,
- bei dem zur Bildung der Speicherknoten (Sp) an den zweiten Gräben (G2) zunächst eine erste Isolationsstruktur (I1) erzeugt wird, so daß die zweiten Gräben (G2) an allen Seiten von isolierendem Material umgeben sind,
- bei dem zur Bildung der Speicherknoten (Sp), nach Erzeugung der ersten Isolationsstruktur (I1), die zweiten Gräben (G2) bis zu einer ersten Höhe (H1) oberhalb der Grenzfläche zwischen der ersten (1) und zweiten Schicht (2) und unterhalb der Grenzfläche zwischen der zweiten (2) und dritten Schicht (3) mit einem vom ersten Leitfähigkeitstyp dotierten Material versehen werden,
- bei dem zur Bildung der Speicherknoten (Sp) anschließend ein Teil der ersten Isolationsstruktur (I1) zwischen der ersten Höhe (H1) und der Oberfläche (4) entfernt wird, wodurch ein Kondensatordielektrikum (Kd) gebildet wird,

- bei dem zur Bildung der Speicherknoten (Sp) anschließend die zweiten Gräben (G2) bis zur einer zweiten Höhe (H2), die oberhalb der ersten Höhe (H1) und unterhalb der Grenzfläche zwischen der zweiten (2) und dritten Schicht (3) liegt, mit einem vom ersten Leitfähigkeitstyp dotierten Material versehen werden,
- bei dem vor Bildung der Gateelektrode (G) ein Gateoxid (I2) erzeugt wird,
- bei dem zur anschließenden Bildung der Gateelektrode (G) die zweiten Gräben (G2) bis zu einer dritten Höhe (H3) oberhalb der Grenzfläche zwischen der zweiten (2) und der dritten Schicht (3) mit einem leitenden Material gefüllt werden, wodurch auch die Wortleitung (Wl) entsteht,
- bei dem nach Bildung der Gateelektroden (G) die zweiten Gräben (G2) bis zur Oberfläche (4) mit isolierendem Material gefüllt werden,
- bei dem die zweiten Source/Drain-Gebiete (S/D2) durch Ausdiffundieren von Dotierstoff des Speicherknotens (Sp) in die zweite Schicht (2) gebildet werden.

11. Verfahren nach Anspruch 10,

- bei dem zur Bildung der ersten Gräben (G1) eine erste $SiO_2$-Schicht (O1) erzeugt und mit Hilfe fotolithografischer Verfahren strukturiert wird, so, daß Halbleitermaterial freigelegt wird,
- bei dem verbleibende Teile der ersten $SiO_2$-Schicht (O1) vor der Erzeugung der Bitleitungen (Bl) entfernt werden,
- bei dem zur Bildung der zweiten Gräben (G2) $SiO_2$ abgeschieden wird, womit die ersten Gräben (G1) gefüllt werden, und anschließend mit Hilfe fotolithografischer Verfahren $SiO_2$ selektiv zu Halbleitermaterial geätzt wird, derart, daß Halbleitermaterial in den zwischen den Kreuzungsgebieten (K) liegenden Gebieten ($\overline{K}$) freigelegt wird,
- bei dem zur Bildung der zweiten Gräben (G2), nach Freilegung des Halbleitermaterials in den zwischen den Kreuzungsgebieten (K) liegenden Gebieten ($\overline{K}$), Halbleitermaterial geätzt wird,
- bei dem das Füllen der zweiten Gräben (G2) mit Material bis zur ersten (H1), zweiten (H2) und dritten Höhe (H3) und bis zur Oberfläche (4) jeweils durch Abscheidung des Materials, wodurch die zweiten Gräben (G2) vollständig gefüllt werden, und anschließendes Ätzen des Materials bis zur ersten (H1), bzw. zweiten (H2) bzw. dritten Höhe (H3) bzw. Oberfläche (4) erreicht wird.

12. Verfahren nach einem der Ansprüche 8 bis 11,

- bei dem zur Bildung der ersten Gräben (G1) vor Erzeugung der $SiO_2$-Schicht (O1) ganzflächig eine Siliziumnitridschicht (Ni) abgeschieden wird,
- bei dem zur Bildung der ersten Gräben (G1) die $SiO_2$-Schicht (O1) und die Siliziumnitridschicht (Ni) mit Hilfe fotolithografischer Verfahren strukturiert wird, so, daß Halbleitermaterial freigelegt wird,
- bei dem verbleibende Teile der Siliziumnitridschicht (Ni) vor der Erzeugung der Bitleitungen (Bl) entfernt werden.

FIG 1

FIG 2

FIG 3

K, G2

O2

T2

2

1

FIG 4

$\overline{K}$

O2

O1

4

3

2

1

FIG 5

FIG 6

**FIG 7**

**FIG 8**

## FIG 9